# EUROPÄISCHE PATENTSCHRIFT

(11) **EP 3 319 233 B1**
(45) Veröffentlichungstag und Bekanntmachung des Hinweises auf die Patenterteilung: **17.02.2021**
(21) Anmeldenummer: 17199621.8
(22) Anmeldetag: 02.11.2017
(51) Int. Cl.: H03K 17/95, H02G 13/00, B61B 12/06, H01G 9/00, H01Q 1/50, H02H 9/04

(54) **INDUKTIVER NÄHERUNGSSCHALTER ZUR LAGEÜBERWACHUNG EINES TRANSIENTEN FÜHRENDEN DRAHTSEILS IN EINER SEILBAHN UND DESSEN VERWENDUNG BEI EINER SEILBAHN**
INDUCTIVE PROXIMITY SWITCH FOR MONITORING THE LOCATION OF A TRANSIENT WIRE CABLE IN A FUNICULAR RAILWAY AND ITS USE IN A FUNICULAR RAILWAY
DÉTECTEUR DE PROXIMITÉ INDUCTIF DESTINÉ À LA SURVEILLANCE DE LA POSITION D'UN CÂBLE MÉTALLIQUE TRANSITOIRE DANS UN TÉLÉPHÉRIQUE ET SON UTILISATION DANS UN TÉLÉPHÉRIQUE

(30) Priorität: 08.11.2016 DE 102016221882; 08.11.2016 DE 102016221883
(43) Veröffentlichungstag der Anmeldung: 09.05.2018
(73) Patentinhaber: ifm electronic gmbh, 45128 Essen (DE)
(72) Erfinder: Hingst, Kai, 88069 Tettnang (DE); Tinyakov, Valeriy, 88074 Meckenbeuren (DE); Strobel, Manfred, 88250 Weingarten (DE)

(56) Entgegenhaltungen:
- EP-A1- 1 530 181
- CN-A- 105 529 695
- DE-A1- 1 538 324
- DE-A1-102014 209 339

## Beschreibung

Die Erfindung betrifft einen Induktiven Näherungsschalter zur Lageüberwachung eines Transienten führenden Drahtseils in einer Seilbahn gemäß dem Oberbegriff des Anspruchs 1, sowie dessen Verwendung gemäß den Ansprüchen 6 und 7. Unter Transienten sollen hier transiente Überspannungen, d. h. Spannungsspitzen verstanden werden, wie sie durch Blitzeinwirkungen bei Gewitter, aber auch durch Schalthandlungen in elektrischen Stromkreisen, Motoren oder durch elektrostatische Entladungen hervorgerufen werden und für einen Zeitraum von Nanosekunden und Mikrosekunden anstehen.

Berührungslos arbeitende Sensoren werden in elektronischen Schaltgeräten vor allem in der Automatisierungstechnik eingesetzt. Sie sind seit langem bekannt und werden u. a. auch von der Anmelderin hergestellt und vertrieben.

Sie bestehen im Wesentlichen aus einem Sensor zur Erfassung von vorzugsweise elektrischen, aber auch optischen oder sonstigen physikalischen Eigenschaften von beweglichen Objekten, wobei die Änderung der betreffenden physikalischen Größe als Maß für die Annäherung eines Objekts dient, und einer Steuereinheit, die bei Erreichen eines Schwellwertes ein vorzugsweise binäres Schaltsignal erzeugt. Nach dem induktiven Sensorprinzip arbeitende Schaltgeräte weisen mindestens eine Sensorspule auf und können mit Stromimpulsen, aber auch mit kontinuierlichem, meist sinusförmigem Wechselstrom betrieben werden. Dabei kann die Sensorspule Bestandteil eines Oszillators sein und so dessen Frequenz mitbestimmen.

Die Sensorspule kann aber auch von einem Generator mit pulsförmigem oder sinusförmigem Strom versorgt werden.

Der Sensor kann auch als Transformator, insbesondere als Differentialtransformator aufgebaut sein, und somit weitere Sende- oder Empfangsspulen aufweisen. Ausgewertet wird die Änderung der Induktivität und/oder die Impedanz einer Spule, bzw. der Koppelfaktor zwischen zwei oder mehreren Spulen.

Wenn ein Näherungsschalter als Seilabtaster zur Überwachung der korrekten Lage eines Drahtseils in einer im Freien befindlichen Seilbahn oder eines Skilifts eingesetzt wird, besteht unabhängig von dessen Sensorprinzip besonders im Hochgebirge die Gefahr von Blitzeinschlägen in das Drahtseil, was zu induktiv oder kapazitiv (elektromagnetisch) eingekoppelten Transienten, insbesondere in der Sensorspule eines derartigen Schaltgeräts führt.

Wie sich in wenig überraschender Weise gezeigt hat, kommt es dadurch zu Schäden an elektronischen Bauelementen, wobei mit der Sensorspule gekoppelte Eingänge von Verstärkern und Mikrocontrollern besonders gefährdet sind.

Es wird angemerkt, dass Seilbahnen bei Gewitter zwar meistens abgeschaltet werden, es aber trotzdem zur Beschädigung von elektronischen Bauelementen und bei nicht abgeschalteter Seilbahn zu Funktionsstörungen kommen kann.

Die EP 1 530 181 A1 beschreibt einen induktiven Kabelpositionssensor für einen Skilift, einen Sessellift oder irgendeine Art von Seilbahn.

Der Kabelpositionssensor ist in der Nähe der Seilrollen angeordnet und überwacht neben der Anwesenheit auch die korrekte Lage des Kabelseils, was durch mehrere Annäherungszonen (zones de proximite) erreicht wird. Das Blitzschutzproblem ist hier nicht erwähnt.

Die EP 0 757 829 B1 offenbart ein System zur Überwachung der Sicherheit einer Seilbahn mit einem nach dem induktiven Sensorprinzip arbeitenden Seilabtaster, wobei allerdings keine speziellen Blitzschutzmaßnahmen vorgeschlagen werden. Die DE 10 2015 221 342 A1 der Anmelderin zeigt eine Blitzschutzvorrichtung mit einem Relais, wobei der Hochpunkt der Sensorspule mit dem Ruhekontakt eines Relais verbunden ist, der bei anliegender Betriebsspannung stets geöffnet und im ausgeschalteten Zustand geschlossen ist, und auf diese Weise als innerer Blitzschutz wirkt. Es besteht jedoch der Wunsch nach einem schneller und vor allem bei anliegender Betriebsspannung wirkenden inneren Blitzschutz.

Die in den Schriften DE 15 13 038 A1, DE 36 26 800 A1 und DE 198 45 281 C2 gezeigten Schutz-Anordnungen mit in die Signalleitungen eingefügten antiparallelen Dioden sind nicht ohne Weiteres auf induktive Näherungsschalter und keinesfalls auf nach dem induktivem Sensorprinzip arbeitende Seilabtaster übertragbar, weil einerseits die bereits oben erwähnte Schwingkreisgüte erhalten bleiben muss, und andererseits wegen der exponierten Lage von Seilbahnen, oft im Hochgebirge, und der vergleichsweise langen Drahtseile zwar schnell ansteigende aber trotzdem lang anhaltende Transienten sowohl induktiv und als auch elektromagnetisch durch Spannungsüberschläge in den Seilabtaster, insbesondere in dessen Sensorspule eingekoppelt werden können.

Die Aufgabe der Erfindung besteht darin, die genannten Nachteile zu überwinden, und einen innerhalb von Nanosekunden aktiven und vor allem auch bei anliegender Betriebsspannung wirkenden inneren Blitzschutz für einen als Seilabtaster geeigneten induktiven Näherungsschalter anzugeben, der sowohl die Sensorelektronik, insbesondere die mit der Sensorspule verbundenen Bauteile, aber auch die nachfolgende elektronische Schaltung mit ihren empfindlichen Mikrocontroller-Eingängen schützt, ohne deren Funktion merklich zu beeinträchtigen.

Diese Aufgabe wird mit den im Patentanspruchs 1 angegebenen Merkmalen gelöst. Die abhängigen Ansprüche betreffen die vorteilhafte Ausgestaltung der Erfindung.

Der wesentliche Erfindungsgedanke besteht darin, den Hochpunkt der Sensorspule, die in der Regel Bestandteil eines Parallelschwingkreises ist, durch eine aus zwei antiparallelen Zweigen bestehende Diodenstrecke mit mindestens je 2 Schutzdioden mit Masse zu verbinden.

Dabei werden die Schutzdioden erfindungsgemäß so ausgewählt, dass sie durch in das Drahtseil oder das nahe Umfeld einschlagende Blitze eingekoppelte Transienten ausreichend unterdrücken, ohne den Gütefaktor des vorzugsweise bei mehreren 100 kHz arbeitenden Schwingkreises messbar zu verringern.

In einer vorteilhaften Ausgestaltung wird die übrige Schaltung, die meistens einen Mikrocontroller mit besonders empfindlichen Eingängen enthält, durch eine zweite Schutz-Schaltung mit einem Tiefpass und einer Zenerdiode oder gleich wirkenden Bauteilen von der mit der Sensorspule verbundenen Eingangsschaltung entkoppelt.

Die Erfindung wird anhand der Zeichnung näher erläutert.
Fig. 1 zeigt ein Blockschaltbild des induktiven Näherungsschalters (Seilabtasters),
Fig. 2 zeigt die Lage des Seilabtasters zwischen den Rollen einer Seilbahnstütze,
Fig. 3 zeigt die Außenansicht eines erfindungsgemäßen induktiven Seilabtasters.

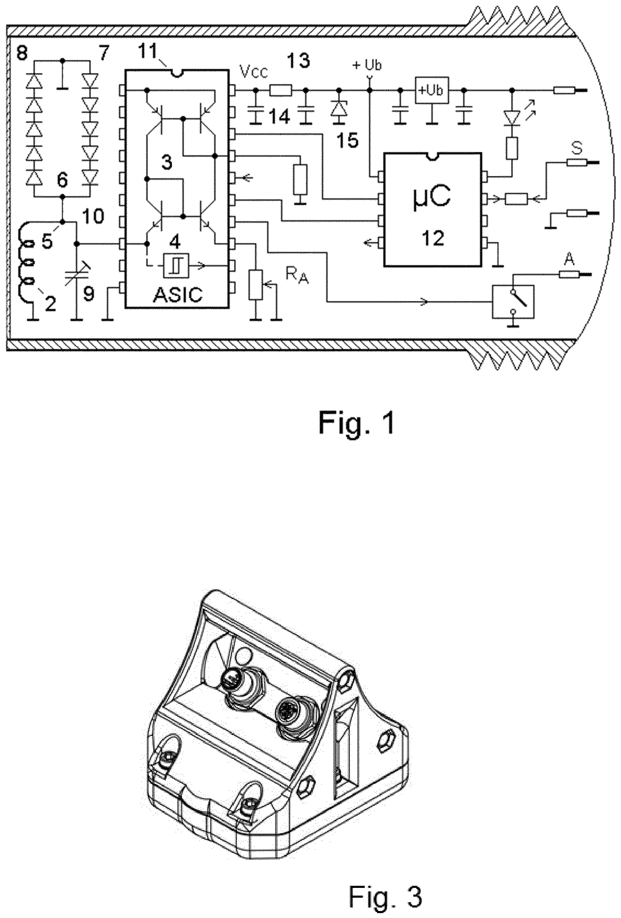

Die Fig. 1 zeigt die wesentlichen Baugruppen des erfindungsgemäßen induktiven Näherungsschalters, der insbesondere zum Nachweis der korrekten Lage eines Drahtseils 1 in seinem Überwachungsbereich geeignet ist, aber natürlich überall dort eingesetzt werden kann, wo transiente Überspannungen zu erwarten sind.

Eine Sensorspule 2 bildet gemeinsam mit der Kapazität 9 einen Schwingkreis 10 mit einem elektronisch ausgewerteten Gütefaktor der von einer als negativer Widerstand wirkenden Oszillator-schaltung 3 entdämpft wird.

Dargestellt ist eine Stromspiegelschaltung, die keine Spulenanzapfung benötigt und im unteren Stromspiegel eine komfortable Abgleichmöglichkeit durch einen Widerstand RA bietet. Der obere Stromspiegel dient zur Rückkopplung.

Näheres dazu ist in der DE 196 50 793 C1 offenbart, was die Erfindung aber nicht auf diese Ausgestaltung des induktiven Näherungsschalters beschränkten soll.

Die Auswerteschaltung 4 steuert die Oszillatorschaltung 3, und ist in der Lage, ein vorzugsweise binäres Schaltsignal anhand der Oszillatoramplitude zu erzeugen Die Oszillatorschaltung 3 und die Auswerteschaltung 4 sind gemeinsam in einem kundenspezifischen Auswerteschaltkreis 11, einem ASIC untergebracht, ohne die Erfindung darauf zu beschränken. Wie bereits erwähnt, kann der ASIC 11 eine Steuerbaugruppe 4 mit einem Schwellwertschalter (Trigger) und einen hier nicht dargestellten Logik-Baustein, beispielsweise einen Mikrocontroller 12 enthalten.

Er kann auch wie gezeigt über Signalleitungen mit einem Mikrocontroller 12 verbunden sein, der auch sicherheitsrelevante Funktionen übernehmen, ein binäres Schaltsignal erzeugen und oder digitale Messwerte seriell ausgeben kann.

Da der Oszillatorstrom durch den Abgleichwiderstand RA festgelegt ist, fällt die Amplitude bei Anwesenheit eines als Schaltfahne wirkenden Drahtseils 1 im Überwachungsbereich ab, was bei Unterschreitung einer vorgegeben Schaltschwelle zur Erzeugung eines binären Schaltsignals führt, das über einen elektronischen Schalter über den Ausgang A ausgegeben werden kann, ohne die Erfindung darauf zu beschränken.

Der Anschluss S ist zur Kommunikation mit einer übergeordneten Steuereinheit geeignet. Darüber hinaus können mit Hilfe verschiedenfarbiger LEDs Lichtsignale erzeugt werden, die den Schaltzustand, einen Fehler, oder ein sonstiges Signal ausgeben.

Es wird angemerkt, dass diese Schaltung zur Überwachung der Mittellage eines Drahtseils doppelt, d. h. mit zwei Sensorspulen 1 und zwei ASICs 11 ausgeführt sein kann.

Die Diodenstrecke 6 dient erfindungsgemäß als inneren Blitzschutz für die gesamte elektronische Schaltung, insbesondere aber für den Auswerteschaltkreis 11.

Sie weist zwei antiparallele Zweige 7 und 8 mit jeweils fünf (Silizium-) Dioden auf. So kann die Eingangsspannung am ASIC 11 die Summe der Flussspannungen der Diodenzweige 7 oder 8 nicht überschreiten, wobei die Diodenzweige auch unsymmetrisch, d. h. unterschiedlich ausgeführt sein können. Die Anzahl der Dioden so gewählt, dass die Summe der Flussspannungen, hier etwa (≈ 0.6 * 5V) ≈ 3V, die maximal zu erwartende Amplitude von ca. 2,4 Volt um die Flussspannung einer Diode übersteigt so dass der bei Zerstörung einer Diode noch voll funktionsfähig bleibt. Um die Beschädigung der übrigen Schaltung, insbesondere des Mikrocontrollers 12 zu vermeiden, ist der Vcc- Anschluss des ASIC 11 mit einer Entkoppelschaltung 13 verbunden, die einen Tiefpass 14 und eine Zenerdiode 15 oder gleich wirkende Bauteile aufweist.

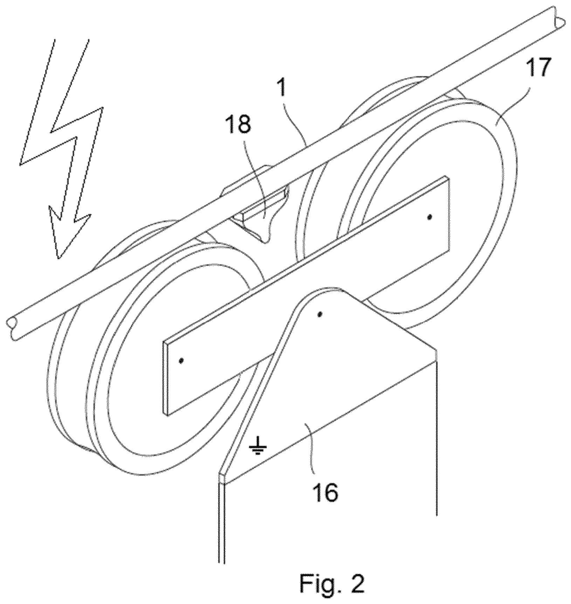

Fig. 2 zeigt eine mögliche Einbaulage des erfindungsgemäßen Seilabtasters 18 in der Seilbahn.

Dargestellt ist die Oberseite einer Seilbahnstütze 16 mit zwei ein elektrisch leitendes Drahtseil 1 tragenden Seilrollen 17. In natura handelt es sich hierbei meistens um eine Rollenbatterie mit mehreren Rollenpaaren.

Die Seilbahnstütze 16 ist über ihr Fundament mit dem Erdreich verbunden, so dass durch Blitzschlag in das Drahtseil 1 erzeugte Transienten mit hohen Spannungen und Strömen induktiv in den Sensor, aber auch durch Funkenüberschlag kapazitiv (elektromagnetisch) in die elektronische Schaltung des Seilabtasters 18 eingekoppelt werden.

Die Rollen 17 sind über ihre Lager geerdet, weil das Fundament der Seilbahnstütze 16 mit dem Erdreich verbunden ist, so dass durch Blitzschlag in das Drahtseil 1 erzeugte Transienten mit hohen Spannungen und Strömen induktiv und/oder kapazitiv in die elektronische Schaltung des an der Seilbahnstütze befestigten Seilabtasters 18 eingekoppelt werden können, was ohne die erfindungsgemäßen Schutzmaßmahnen zu dessen Zerstörung führen könnte.

Das Gehäuse des Seilabtasters 18 kann aus Metall, aber auch wie in diesem Fall aus Kunststoff bestehen. Es ist ebenfalls elektrisch mit der Seilbahnstütze 16 verbunden, so dass eine elektromagnetische Störeinkopplung nicht nur wegen des induktiven Sensors prinzipiell praktisch unvermeidbar ist.

Das Gehäuse des Seilabtasters 18 besitzt in der Regel eine elektrisch isolierende Frontfläche, aber selbst ein Ganzmetallsensor würde das Problem wegen in der Gehäusewand induzierter Impulsströme nicht lösen.

Der in Fig. 1 dargestellte erfindungsgemäße induktiven Näherungsschalter wird hier als Seilabtaster 18 zur Überwachung der korrekten Lage eines elektrisch leitfähigen Drahtseils 1 in einer Seilbahn verwendet, wobei eine induktive Kopplung zwischen dem Drahtseil 1 und der hier nicht dargestellten Sensorspule 2, sowie die Möglichkeit transienter elektrischer Entladungen zwischen dem Drahtseil 1 und einer geerdeten Seilbahnstütze 16 gegeben ist.

Fig. 3 zeigt die Außenansicht eines zur Überwachung der Lage eines elektrisch leitfähigen Drahtseils 1 in einer Seilbahn geeigneten induktiven Näherungsschalters (Seilabtasters) 18.

Da die Überwachung einer Seilbahn eine größere Anzahl derartiger Seilabtaster 18 weist er einen Kabelstecker und eine Kabeldose auf, so dass er zum Durchschleifen geeignet ist.

Der induktive Sensor und die Auswerteschaltung sind wie in der Fig. 1 beschrieben. Das gezeigte Gerät ist vorteilhaft als Sicherheits-Näherungsschalter mit mindestens zwei Sensorsystemen und einer eigensicheren Auswerteschaltung ausgeführt.

### Bezugszeichenliste

- 1: Drahtseil
- 2: Sensorspule
- 3: Oszillatorschaltung
- 4: Auswerteschaltung mit einem Trigger
- 5: Hochpunkt der Sensorspule 2 und ggf. auch des Schwingkreises 10
- 6: Diodenstrecke mit zwei antiparallelen Zweigen 7 und 8
- 7: Erster Diodenzweig
- 8: Zweiter Diodenzweig
- 9: Schwingkreiskondensator (Schwingkreiskapazität)
- 10: Schwingkreis, bestehend aus der Sensorspule 2 und dem Kondensator 9
- 11: Auswerteschaltkreis mit Oszillator, Trigger und Logik-Baustein (ASIC, FPGA)
- 12: Mikrocontroller, Steuereinheit
- 13: Entkoppelschaltung zwischen dem ASIC 11 und dem Mikrocontroller 12
- 14: Tiefpass, gehört zur Entkopplungsschaltung 13
- 15: Zenerdiode, gehört zur Entkopplungsschaltung 13
- 16: Seilbahnstütze, geerdet
- 17: Seilrolle
- 18: Seilabtaster (induktiver Näherungsschalter)

## Patentansprüche

1. Induktiver Näherungsschalter zur Lageüberwachung eines Transienten führenden Drahtseils (1) mit einer Sensorspule (2) zur Erzeugung eines magnetischen Wechselfeldes in einem Überwachungsbereich, mit einer Oszillatorschaltung (3) zur Speisung der Sensorspule (2) und einer damit verbundenen Auswerteschaltung (4) zur Erzeugung eines Schaltsignals, **dadurch gekennzeichnet, dass** der Hochpunkt (5) der Sensorspule (2) mit einer Diodenstrecke (6) verbunden ist, die zwei antiparallele Zweige (7, 8) mit mindestens je zwei Dioden aufweist, und als innerer Blitzschutz wirkt.

2. Induktiver Näherungsschalter gemäß Anspruch 1, **dadurch gekennzeichnet, dass** die Summe der Flussspannungen der Dioden jeder der antiparallelen Zweige (7, 8) der Diodenstrecke (6) um die Flussspannung einer Diode größer ist als die maximal zu erwartende Signalamplitude.

3. Anordnung gemäß Anspruch 1 oder 2, **dadurch gekennzeichnet, dass** die Sensorspule (5) mit einem Schwingkreiskondensator (9) einen Parallelschwingkreis (10) bildet, dessen Gütefaktor elektronisch ausgewertet wird.

4. Induktiver Näherungsschalter gemäß Anspruch 1 oder 2, **dadurch gekennzeichnet, dass** er einen Auswerteschaltkreis (11) zur Erfassung des Sensorsignals und einen Mikrocontroller (12) zur Weiterverarbeitung aufweist, wobei der Mikrocontroller (12) und der Auswerteschalkreis (11) durch eine Entkoppelschaltung (13) mit dem Auswerteschaltkreis (11) verbunden sind, wobei die Entkoppelschaltung (13) einen Tiefpass (14) und eine Zenerdiode (15) oder gleich wirkende Bauteile aufweist.

5. Induktiver Näherungsschalter nach einem der vorhergehenden Ansprüche, **dadurch gekennzeichnet, dass** er als Sicherheits-Näherungsschalter mit mindestens zwei Sensorsystemen und einer eigensicheren Auswerteschaltung ausgeführt ist.

6. Verwendung des induktiven Näherungsschalters nach einem der vorhergehenden Ansprüche zur Überwachung der Lage eines elektrisch leitfähigen Drahtseils (1) in einer Seilbahn, wobei eine induktive Kopplung zwischen dem Drahtseil (1) und der Sensorspule (2), sowie die Möglichkeit transienter elektrischer Entladungen zwischen dem Drahtseil (1) und einer geerdeten Seilbahnstütze (16) gegeben ist.

7. Anordnung zur Lageüberwachung eines Drahtseils (1) in einer Seilbahn mit auf einer Seilbahnstütze (16) angeordneten Seilrollen (17) und einem dort befestigten Seilabtaster (18) gemäß Anspruch 1.

## Claims

1. Inductive proximity switch for monitoring the position of a transient-conducting wire cable (1), having a sensor coil (2) for generating an alternating magnetic field in a monitoring region, having an oscillator circuit (3) for feeding the sensor coil (2) and an evaluation circuit (4) connected thereto for generating a switching signal, **characterized in that** the top (5) of the sensor coil (2) is connected to a diode path (6) that has two anti-parallel branches (7, 8), having at least two diodes in each case, and acts as internal lightning protection.

2. Inductive proximity switch according to Claim 1, **characterized in that** the sum of the forward voltages of the diodes in each of the anti-parallel branches (7, 8) of the diode path (6) is greater by the forward voltage of a diode than the maximum signal amplitude that is to be expected.

3. Arrangement according to Claim 1 or 2, **characterized in that** the sensor coil (5) forms a parallel resonant circuit (10) with a resonant circuit capacitor (9), the quality factor of which circuit is electronically evaluated.

4. Inductive proximity switch according to Claim 1 or 2, **characterized in that** it has an evaluation circuit (11) for detecting the sensor signal and a microcontroller (12) for further processing, wherein the microcontroller (12) and the evaluation circuit (11) are connected to the evaluation circuit (11) by way of a decoupling circuit (13), wherein the decoupling circuit (13) has a low-pass filter (14) and a Zener diode (15) or functionally identical components.

5. Inductive proximity switch according to one of the preceding claims, **characterized in that** it is designed as a safety proximity switch having at least two sensor systems and an inherently safe evaluation circuit.

6. Use of the inductive proximity switch according to one of the preceding claims for monitoring the position of an electrically conductive wire cable (1) in a cable car, wherein there is inductive coupling between the wire cable (1) and the sensor coil (2) and there is the possibility of transient electrical discharges between the wire cable (1) and an earthed cable car support (16).

7. Arrangement for monitoring the position of a wire cable (1) in a cable car having cable pulleys (17) arranged on a cable car support (16) and a cable detector (18) according to Claim 1 fastened thereto.

## Revendications

1. Détecteur de proximité inductif destiné à surveiller la position d'un câble métallique (1) conduisant des transitoires, comprenant une bobine de capteur (2) destinée à générer un champ magnétique alternatif dans une zone de surveillance, comprenant un circuit oscillateur (3) destiné à alimenter la bobine de capteur (2) et un circuit d'interprétation (4) relié à celui-ci pour générer un signal de commutation, **caractérisé en ce que** le point haut (5) de la bobine de capteur (2) est relié à un segment à diodes (6), qui possède deux branches en tête-bêche (7, 8) comprenant chacune au moins deux diodes, et qui fait office de parafoudre interne.

2. Détecteur de proximité inductif selon la revendication 1, **caractérisé en ce que** la somme des tensions directes des diodes de chacune des branches en tête-bêche (7, 8) des segments à diodes (6) est supérieure, de la tension directe d'une diode, à l'amplitude de signal maximale attendue.

3. Agencement selon la revendication 1 ou 2, **caractérisé en ce que** la bobine de capteur (5) forme avec un condensateur de circuit oscillant (9) un circuit oscillant parallèle (10) dont le facteur de qualité est évalué électroniquement.

4. Détecteur de proximité inductif selon la revendication 1 ou 2, **caractérisé en ce qu'**il possède un circuit d'interprétation (11) destiné à acquérir le signal de capteur et un microcontrôleur (12) destiné au traitement ultérieur, le microcontrôleur (12) et le circuit d'interprétation (11) étant reliés au circuit d'interprétation (11) par un circuit de découplage (13), le circuit de découplage (13) possédant un filtre passe-bas (14) et une diode zener (15) ou des composants ayant le même effet.

5. Détecteur de proximité inductif selon l'une des revendications précédentes, **caractérisé en ce qu'**il est réalisé sous la forme d'un détecteur de proximité de sécurité comprenant au moins deux systèmes capteurs et un circuit d'interprétation à sécurité intrinsèque.

6. Utilisation du détecteur de proximité inductif selon l'une des revendications précédentes pour la surveillance de la position d'un câble métallique (1) électriquement conducteur dans un téléphérique, un couplage inductif entre le câble métallique (1) et la bobine de capteur (2), ainsi que la possibilité de décharges électriques transitoires entre le câble métallique (1) et un pylône de téléphérique (16) étant établis.

7. Arrangement de surveillance de la position d'un câble métallique (1) dans un téléphérique comprenant des poulies (17) disposées sur un pylône de téléphérique (16) et un palpeur de câble (18) selon la revendication 1 qui y est fixé.
